# EUROPEAN PATENT APPLICATION

(11) **EP 4 202 582 A1**
(43) Date of publication of application: **28.06.2023**
(21) Application number: 21216479.2
(22) Date of filing: 21.12.2021
(51) Int. Cl.: G05B 19/418

(54) **METHOD OF OPERATION OF A PROCESS PLANT, SOFT SENSOR AND DIGITAL PROCESS TWIN SYSTEM AND USE THEREOF**

(71) Applicant: Siemens Aktiengesellschaft, 80333 München (DE)
(72) Inventor: The designation of the inventor has not yet been filed
(74) Representative: Siemens Patent Attorneys

(57) **Abstract**

What is proposed is a method of operation of a process plant with at least one automation component (PA) to control an industrial process (MP) within the process plant with at least one input ingredient and at least one output product, the method comprising the steps of:
- generating quality attributes of the industrial process as a function of process variables and process parameters using a non-real-time simulation model (OSM) of the industrial process,
- using the generated quality attributes and related process variables as input for a machine learning model (ML) which is used as real-time process model (RT-PRM),
- using the real-time process model (RT-PRM) as a soft sensor to estimate quality attributes (QA) of the output product as a function of measured or simulated process variables of the industrial process, and
- optimizing the performance of the process plant based on the estimated quality attributes (QA) of the output product. Additionally, a corresponding digital process twin system is proposed. The proposed method and system allow process operations and control that are faster, more efficient, and more reliable.

## Description

The present disclosure is directed to a method of operation of a process plant comprising at least one automation component to control an industrial process within the process plant with at least one input ingredient and at least one output product, according to claim 1. Furthermore, the present disclosure is directed to a soft sensor according to claim 6 and a digital process twin according to claim 10.

Combining technologies from automation, simulation and digitalization in a seamless way enables the next step of digital transformation towards a more efficient and sustainable industrial production with higher quality standards.

Particularly in the context of automation of industrial processes for production processes and manufacturing, there are many applications for computer-implemented representations of real objects or processes, so-called "digital twins". Digital twins are virtual constructs of physical systems that mirror the behavior, performance, and dynamics of such physical systems.

By incorporating multi-physics simulation, process modelling techniques and even artificial intelligences, digital twins are able to demonstrate the impact of design changes, usage scenarios, environmental conditions, and other endless variables - eliminating the need for physical prototypes, reducing development time, and improving quality of the finalized product or process.

When designing a pharmaceutical production process for example, one of the most important key parameters of the production process is the product quality. It is important that the product quality is safeguarded when upscaling, transferring or automating process operations. To this end, many engineering runs and (offline) quality measurements are required which slow down time-to-market and which are costly. As it is not always possible to assess the quality in real-time, samples must be taken manually to be measured offline. The result of the quality then comes after the sample has been transferred and measured by the quality control laboratory. This continuous process verification is often inefficient and inconsistent. Additionally, the ingredients in pharmaceutical production processes mostly are very expensive. High cost of experimentation and production, hence also high cost of generating data, the data often being distributed to different data silos, is also a major drawback to enable data driven (machine learning) models in the pharmaceutical industry. Therefore, there is a critical need to examine the progress of the pharmaceutical industry towards implementing digital twin solutions. An overview over approaches with Digital Twins in pharmaceutical and biopharmaceutical manufacturing is given in the literature: Y, Chen, O. Yang, C. Sampat, P. Bhalode, R. Ramachandran and M. Ierapetritou: "Digital Twins in Pharmaceutical and Biopharmaceutical Manufacturing: A Literature Review": Processes 2020, Volume 8, Issue 9, page 1088; published in Sep. 2020.

However, a consistent solution for a sustainable process development - reducing overall experimentation time and waste, ensuring constant quality and moving to new "quality by design" opportunities (i.e., the shifting of previously downstream quality controls into the manufacturing process) to get the product right within a short time limit and to reduce malproduction, is missing.

An objective of the present invention is therefore to mitigate the problems identified and to provide an improved method to operate an industrial process plant, and a respective digital twin solution, for a more time-and cost- efficient production process ensuring highest quality standards, reducing waste and the usage of expensive raw materials.

The problem is solved by a method of operation of a process plant according to claim 1. Furthermore, the problem is solved by a soft sensor for a process plant according to claim 6 and a digital twin (solution) according to claim 10. Advantageous aspects of the invention are the subject of the dependent claims.

According to the invention a method of operation of a process plant comprising at least one automation component to control an industrial process within the process plant with at least one input ingredient and at least one output product is proposed, the method comprising the steps of:
- generating quality attributes of the industrial process as a function of process variables and process parameters using a non-real-time simulation model of the industrial process,
- using the generated quality attributes and related process variables as input for a machine learning model which is used as real-time process model,
- using the real-time process model as a soft sensor to estimate quality attributes of the output product as a function of measured or simulated process variables of the industrial process, and
- optimizing the performance of the process plant based on the estimated quality attributes of the output product.

The industrial process should be understood as any process in technology, in which a product is created from a raw material. In those processes the raw material is changed in terms of composition, type or properties using physical, chemical, or biological methods. In the disclosure herein the industrial process does not include sensors, actuators or any instruments used to measure process variables, to move and control process components and to analyze process materials. The automation system with all its automation functions which is configured to control the process with all its components should be understood as part of the technical or process plant, but not as part of the industrial process.

Process variables should be understood as measurable physical property of an industrial process which is being monitored or controlled. An example of this would be the temperature, flow, level, or pressure. A measured temperature is called the process variable, while the desired temperature is known as set-point. In this disclosure however, process variables may be measured or simulated by a simulation software tool. Based on simulation models real-time simulation of automation projects may also create process variables as digital representatives of an industrial process.

Process parameters should be understood as configuration parameters internal to the process like material parameters or any quantity that influences the output or behavior of the process. In a function F(x) = ax + b, x is a variable and a, b are parameters. Model parameters also could be understood as process parameters in this disclosure.

There are multiple advantages of the invention with regard to several aspects. First, the presented solution offers the unique possibility to simulate a slow process by using a non-real-time simulation model and using the simulated output data of that model as input for a real-time data-driven process model of a fast process. The approach of using slow physical modelling to generate data for a fast real-time data driven machine learning model helps to overcome the limitation of computing power in a real-time or any fast process. The machine learning model could be seen as a faster and more accurate version of the offline model. As there is no time during a real-time process to wait many hours for a result of a "slow" offline model, the simulation data for the machine learning model are generated mostly in advance. However, if the offline simulation does not need high computing power and time, a parallel execution of the offline model should be possible too.

Additionally, it is a great advantage, that the simulation model of the industrial process can be designed, optimized, and verified with experiments offline in advance. This again is especially advantageous if the simulation of the process is slow and/or takes a lot of computing power. The offline simulation can be carried out typically with super computers or cloud computing. For very complex processes the simulation might take hours or even days. An integration into the plant runtime is not possible in those cases. The results of the offline simulation model are collected in simulation files, which can be fitted and/or verified with test experiments from laboratory. The offline simulation model can be tailored to the respective use-case and tested with experiments. The laboratory experimental data can be used to fit the offline simulation model and for fine-tuning of the model parameters to have the same results in simulation as for experiments. This way also training data for the subsequent data driven model can be achieved, when the process knowledge is small or no historical data exist.

Besides this time aspect the real-time process model can be used as a soft sensor to estimate quality attributes of the output product of the process. Those estimated quality attributes of the output product can be verified by offline laboratory sample measurements and analysis like process analytical technologies. This way a continuous process verification takes place. Each model used can be improved and adjusted based on the offline verification in order to raise the quality of the output product. However, in a very advantageous way the quality attribute estimations can be based on measured process variables as well as on simulated process variables. This allows more flexibility to an operator. It also means that the operator may already optimize the performance of the plant before the plant is running and in operation. The operator may optimize any values to be set, the set-points of the process variables and the process parameters based on the soft sensor output.

In a further advantageous embodiment of the invention a process plant simulation model is used to generate the simulated process variables of the industrial process. In this embodiment automation functions and so-call standard functions of the process automation are taken into consideration to improve the data-driven process model and to build a better representation of the plant. Sensors may be simulated by simulation software just as Programmable Logic Controllers PLCs (so called soft-PLCs) or other automation and control functions. At the same time the simulation of the plant may be varied and optimized in advance. Using the simulated data, the soft sensor evolves and continuously updates to reflect any change to input variables and parameters creating a closed-loop of feedback in a virtual plant environment that enables an operator to continuously optimize the output product, the way of production, and the plant performance at minimal cost.

According to another very advantageous embodiment of the invention the process plant simulation model is a real-time model and the real-time process plant simulation model and the real-time process model are combined to a real-time virtual plant model to estimate or predict states of the process plant to optimize the performance of the process plant. By converting the plant model to real-time, a full representation of the process and the plant in the form of a real-time digital process twin is achieved. This way the virtual plant model may be fully integrated into the running real plant environment in real-time. Using the data from the soft sensor in this plant environment in real-time ensures constant quality of the industrial process by shifting quality controls into the industrial plant thus accelerating the production. Thus, a consistent solution for a sustainable process development is presented.

In an advantageous embodiment of the invention is the real-time process model or the real-time virtual plant model used for an online control of the process plant, which is preferably an advanced, adaptive process control. In this case the already existing models can be integrated in advanced control concepts, which are model-based and adaptive. The most powerful and most successful control method for multivariable control in process industries are model predictive controllers. Since the optimization of the process plant is built on an extensive modelling of the process (using different modelling techniques) it is especially advantageous to use those models such as the virtual plant model as process model for a model predictive controller. Fast, real-time online control allows to minimize fluctuations of the output product quality during a constant production and to achieve time-optimal operation of a process plant. Those controls can be fit exactly to the respective use-case and reach high accuracy. In this embodiment a closed-loop control on quality of the output product can be achieved.

The proposed method of operation of a process plant can be used especially advantageously for pharmaceutical production processes, where the virtual plant model comprises a pharmaceutical production plant with the simulation model describing a chemical process. In a very advantageous embodiment, the proposed solution is used for a mixture process of two liquids such as a mixing of an aqueous phase of a first ingredient and an organic phase of a second ingredient. Especially if a process needs to be performed with costly material with a lot of effort as verification in laboratory (for example with a large number of experiments), quality attribute estimation - either in advance of the production or integrated into the industrial process plant environment - can accelerate significantly the production of a pharmaceutical product.

A second aspect of the present disclosure provides a soft sensor for a process plant with at least one automation component to control an industrial process within the process plant with at least one input ingredient and at least one output product, comprising:
- an interface to receive quality attributes and related process variables of the industrial process from a non-real-time simulation model component to simulate the behavior of the industrial process, and
- a real-time process model component,

comprising a machine learning model,
wherein the machine learning model is based on the received quality attributes and related process variables of the simulation model component, and
wherein the machine learning model is configured to estimate quality attributes of the output product as a function of measured or simulated process variables of the industrial process.

A soft sensor should be understood as not existing real sensor or as virtual sensor, which depicts a dependency simulation of representative measured variables to a target variable. Thus, the target variable is not measured directly, but calculated on the basis of correlated measured variables. The correlation is determined with the help of a model. The function of a soft sensor is therefore defined by a model, which reflects the correlations between measured and target variables.

The soft sensor may be implemented without the non-real-time simulation model component only comprising an interface to the model component or it may be implemented with the non-real-time simulation model component. With other words, in an advantageous embodiment may the soft sensor further comprise the non-real-time simulation model component connected to that interface. This embodiment may be especially advantageous for rather fast processes which are on a similar time scale like the real-time process model component.

In most cases however, the behavior of the industrial process will be modelled in a non-real-time simulation model component. Simulations of the dynamics of the process may be performed, set-points may be determined and the model will be fitted. Laboratory experiments may be used to fit the simulation model. There may be a fine tuning of the model parameters to have the same results in simulation as during experiments. Multiple experiments (for example on a supercomputer) may be run to generate the simulated data (here the quality attributes and related process variables). Those data are fed to a machine learning model, representing a real-time process model, thus creating the soft sensor for the quality attributes of the output product. At this stage, when the results are successful, a monitor of critical quality attributes is achieved to increase the process knowledge and to optimize the process with different parameters or different model designs without the usage of expensive raw materials as input ingredients.

In another advantageous embodiment may the soft sensor further comprise a Kalman filter which is configured to receive the estimated and measured quality attributes of the output product and to calculate improved estimates based on probabilities of previous and current estimates and measured values of the quality attributes. This means that the soft sensor can be augmented with process variable measurements to apply a Kalman filter for better operation or control of the plant. In this case, for example PAT sensor measurements are taken into account and probabilities of the measured and estimated quality attributes can be used to calculate improved estimates based on probabilities of previous and current estimates and based on measured values of the quality attributes.

A third aspect of the present disclosure provides a digital process twin system for a process plant with at least one automation component to control an industrial process within the process plant with at least one input ingredient and at least one output product. The digital process twin system is comprising a virtual plant model component with
- an interface to receive quality attributes and related process variables of the industrial process from a non-real-time simulation model component to simulate the behavior of the industrial process,
- a real-time process model component,
   comprising a machine learning model,
   wherein the machine learning model is based on the received quality attributes and related process variables of the non-real-time simulation model component, and
- a process plant simulation model component,

which is configured to simulate automation functions and operation of the process plant to generate simulated process variables,
wherein the machine learning model is configured to estimate quality attributes of the output product as a function of measured or the simulated process variables of the industrial process.

Thus , the digital process twin comprises a virtual plant model component with the components of the soft sensor and a process plant simulation model component which is configured to simulate automation functions and operations of the process plant to generate simulated process variables. The machine learning model of the virtual plant model component is configured to estimate quality attributes of the output product as a function of measured or the simulated process variables of the industrial process.

Unlike known digital twins, which use measured data to create a virtual representation to predict how a product or process will perform, the digital process twin as described above may also use simulated data generated by a complex physical non-real-time simulation model to estimate quality attributes of the output product. This way all advantages as described for the claimed method of plant operation can be achieved. The digital process twin may be used as stand-alone version or in connection or coupling with a real process plant.

The proposed digital process twin with all its embodiments is not only enabled to replicate the industrial process in order to monitor the process and to predict how the process will perform by soft sensing the quality attributes of the output product but also is enabled to mimic the experiments for determination of the quality attributes of the output product that normally are done in a physical way in a laboratory and to replace them in a virtual way. This way the number of experiments can be reduced substantially.

The digital process twin may be implemented in several embodiments:
If the digital twin system is operated with real-time data of the process plant, the system may provide the estimations of the quality attributes immediately. The performance of the digital process twin system can even be improved if the process plant simulation model is a real-time model. The impact of changes in the engineering of the process plant on the quality of the process output product may then be observed immediately. In both cases the digital twin system may be operated as stand-alone system for example outside of the site of a plant.

For coupling with a real plant, the digital process twin system may be operated in parallel to the process plant with real-time data of the process plant. This way the system may provide the estimations of the quality attributes in real-time and a very fast reaction to quality changes may be provided based on the interaction between the virtual and real plant.

In an advantageous embodiment, the real-time virtual plant model component of the digital process twin is configured to be run in connection with a control component, preferably a model predictive controller, to control the real plant based on the estimated or predicted states generated by the real-time virtual plant model thus providing a closed-loop control of quality of the output product. This allows a combination with any control components to manipulate the real plant based on the predicted states of the real-time virtual plant model. The production of pharmaceutical products for example can be improved and accelerated this way and highest quality standards can be fulfilled.

In a very advantageous embodiment, the virtual plant model component of the digital process twin comprises an interface to provide the simulated process variables and/or the estimated quality attributes to a model predictive controller for tuning the model predictive controller for operation in the real plant. This allows an operator to find optimal starting parameters for control of the process plant. The model predictive controller may especially be tuned before the real plant is operated, what saves a lot of time to find the right starting parameters.

As used herein, the terms "component" and "system" are intended to encompass hardware, software, or a combination of hardware and software. Thus, for example, a system or component may be a data processing means being executed on a processor, or a processor. A processor corresponds to any electronic device that is configured via hardware circuits, software, and/or firmware to process data. A processor described herein may also correspond to a virtual processor of a virtual machine being executed in a physical processor. Additionally, a component or system may be localized on a single electronic device or distributed across several electronic devices. Thus, the digital process twin system of the present disclosure can be realized in any computing systems or environments, that may include a communication mechanism such as a system bus for communicating information within the computer system, one or more processors coupled with the system bus for processing information. The processors may include one or more central processing units (CPUs), graphical processing units (GPUs), or any other processors known in the art. Alternatively, such a digital twin system may also reside in the cloud. Among other aspects, a digital twin may leverage powerful simulation software to validate and optimize production properties. In alternate embodiments, the system may be implemented on a dedicated server. The digital twin may further comprise a simulation platform configured to execute a simulation of the physical process or the plant using the different process/plant models. The simulation platform may include appropriate physics libraries for solving a physical and/or process simulation of the physical process or plant based on defined constraints.

The embodiments of the present disclosure may be implemented with any combination of hardware and software. In addition, the embodiments of the present disclosure may be included in one or more computer program products having, for example, computer-readable, non-transitory media. The media has embodied therein, for instance, computer readable program code for providing and facilitating the mechanisms of the embodiments of the present disclosure.

Features of examples of the present disclosure will become apparent by reference to the following description of an exemplary embodiment of the invention.

Thus, the invention is explained below using examples with reference to the figures, in which:
- Figure 1: illustrates an embodiment of an industrial process plant with an implemented mixing process of two liquids
- Figure 2: illustrates a simplified block diagram of a digital process twin in accordance with an exemplary embodiment of the present disclosure
- Figure 3: illustrates a simplified block diagram of a control architecture in accordance with an exemplary embodiment of the present disclosure

As an example of an application of the invention, an exemplary process plant is described as one possible embodiment of the present invention. Within a technical or process plant with all its technical components as pipes, instruments and automation components, an industrial process is realized. Examples for industrial processes, as applicable for the present invention, could be the production or transformation of a substance of a certain raw material in a reactor, a physical process like mixing or heating or any other process where substances are changed according to type, property and composition to form a new (changed) product. Concrete examples for such processes are shredding, grinding, cooling, filtration, distillation, oxidation, or polymerization.

Thus, the invention is applicable to all chemical or pharmaceutical production plants comprising at least one automation component or an automation system to operate or control an industrial process with at least one input ingredient and at least one output product.

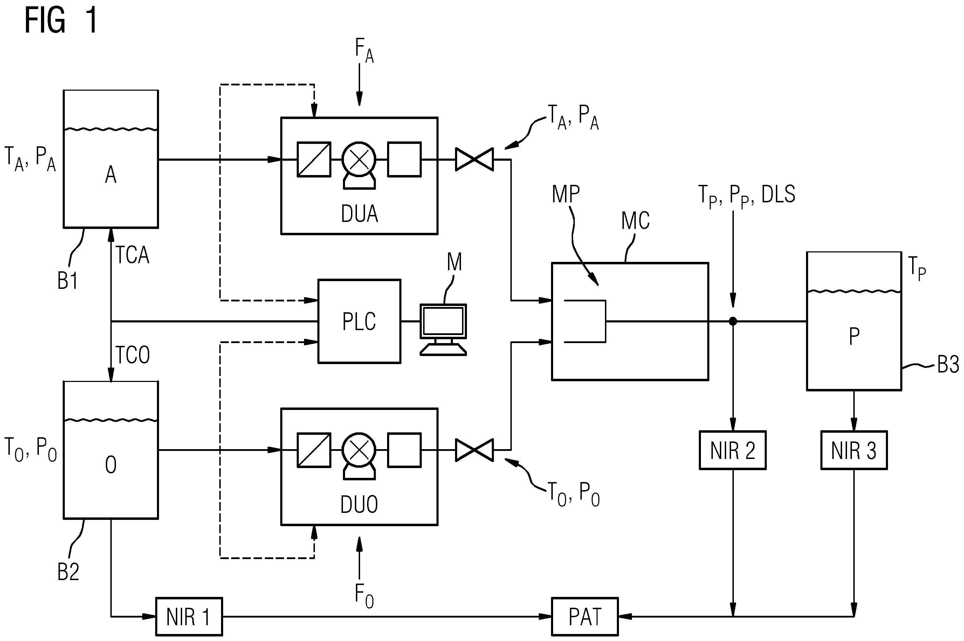

With reference to Fig. 1, a mixing process of two ingredients within a process plant is demonstrated as example and will be the basis for the design and concept of a digital process twin. A mixing process is a basic operation in mechanical process engineering. It serves to unite at least two starting ingredients of different materials, which have different properties, to form a product of a new material. The aim is to achieve the highest possible quality of the product. This is achieved when a random sample reflects certain quality attributes such as the ratio of the starting ingredients with defined accuracy, homogeneity, the average particle size and variance.

In the embodiment of Fig. 1 two liquids are mixed. Liquid from two input tanks B1 and B2 is pumped into a mixing chamber MC. Tank B1 contains for example an aqueous phase with a first ingredient A at temperature TA, which is controlled by a temperature controller TCA, which is communicatively connected to a programmable logic controller PLC. Tank B2 contains for example an organic phase with a second ingredient O at temperature TO, which is controlled by a temperature controller TCO, which - in this embodiment - is communicatively connected to the same programmable logic controller PLC as in case of the aqueous phase. A connection to another PLC is also possible. The temperatures TA and TO and the pressures PA and PO in each tank are measured with sensors and represent process variables. Additionally, NIR (Near Infrared) spectroscopy NIR1 is used to measure chemical composition of the second ingredient O in the input tank B2 of the organic phase.

The mixing chamber MC needs to be filled with highest precision, thus the input parameters, especially the flows of each mixing ingredient, have to be controlled by a respective dosage unit DUA and DUO. Each dosage unit (DUA of the aqueous phase and DUO of the organic phase) may contain a filter, a pump, and a flowmeter. The pumps need to be controlled tightly to maintain proper flow rates FA and FO and flow rate ratios, so the mixing process product forms correctly in the mixing chamber MC. When these flows as process parameters are not optimized, the particles size of the mixing product can be too small, too big or contain not enough active ingredient (the quality attributes). Therefore, a control loop between the dosage units DUA, DUO and the programmable logic controller PLC is implemented. Alternatively, the PLC module can be substituted by a whole automation concept, defining the interaction of various individual automation components, software tools and associated services to form an integrated automation solution or control system (PLC and monitor M).

At the input side of the mixing chamber MC sensors are measuring temperature TA, TO of the input ingredients and pressure PA, PO in the respective pipelines. At the output side of the mixing chamber MC, sensors are not only measuring the temperature TP of the output product and the pressure PP in the respective pipeline but also the particle size by a DLS (Dynamic Light Scattering) system and the composition by a further near infrared spectrometer NIR2. The product P of the mixing process, is gathered in an output tank B3 and again the composition is measured (NIR3) and the temperature TP. Thus, a plurality of process variables is measured and quality attributes are determined.

All process analytical data delivered by the NIR spectrometers NIR1 ... NIR3 and the DLS device are collected in a PAT module. There a process analytical technology (PAT) software monitors the product quality in real-time. The software stores all during the operational execution of a PAT method measured data and performs data correlations and analysis based on mainly statistical but also physical models. All so-called critical-to-quality attributes (CQA) can be captured and transferred for example to a process control system to control the industrial process.

Out of all those data (measured process variables, PAT measurements, PAT derivatives such as chemical compositions, particle sizes, dispersity index and so on) control parameters, set-points and a plurality of parameters for the design of the required models are derived.

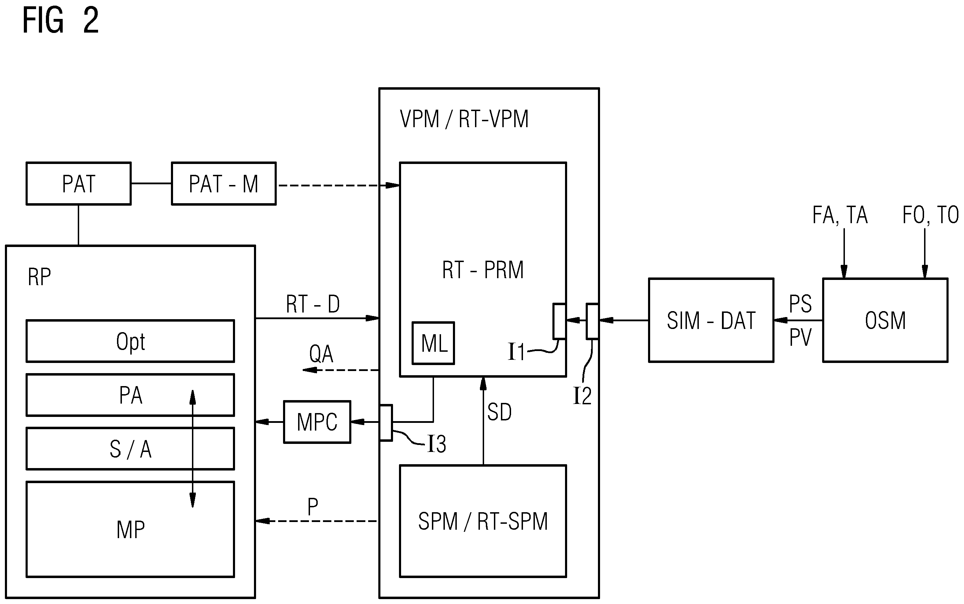

Now turning to Fig. 2, a simplified block diagram is shown illustrating an exemplary system including a digital process twin for the exemplary chosen mixing process as described above. However, the architecture of the digital process twin system may be applied to any other industrial process as mentioned above.

In an industrial process engineering environment, the exemplary mixing process MP will be realized within a technical plant or process plant RP in process industries like a chemical or a pharmaceutical plant. Sensors S or measurement transducer for detecting a process variable in the process (here MP) will interact with a controller being part of an automation layer PA which causes an adjustment element or actuator A to influence the process as a function of the detected process variable. The adjustment operations are performed using conventional control devices in the form of open-loop controls or closed-loop controls.

In such a process plant the process will be executed by automation components or an automation system depicted in Fig. 2 as process automation layer PA. For the set-up of the process automation the requirements for the process are determined by way of planning and system engineering. Subsequently the requirements for the process are translated in a mechanical concept comprising the hardware necessary to perform the process. The detailed concept may be influenced by the requirements determined and the specific properties of the automation components and/or the substance, in particular here the fluids, that are processed. The required automation components may comprise software and/or hardware. Thus, the plant RP comprises at least one automation component to perform an action according to at least one of control parameters of a set of control parameters for controlling operation of an automation system. Often the automation layer PA may be connected to an optimization layer Opt, which could be configured in this embodiment to interact with the digital twin of the virtual plant model.

As described in the context of Fig. 1 the process plant may also be connected to process analytics technology tool PAT for quality control. Based on physical and statistical models PAT-M included in the PAT tool software, predictions of critical-to-quality attributes may be calculated and may be used for later verification of the digital process twin.

For the evolution of a digital process twin according to this disclosure, the behavior of the mixing process is simulated in a first step.

The mixing process in this embodiment is simulated by computational fluid dynamics (CFD) models in co-simulation with nucleation models of crystallization modeling. For the CFD modelling the geometry of the mixing chamber is considered, for the nucleation models knowledge of the interactions on a molecular (bio-chemical) level needs to be taken into account. The inputs to this simulation model OSM are all potential combinations of laboratory condition parameters and set-points, as for example temperature TA and flowrate FA of the aqueous phase of the first ingredient A and temperature TO and flowrate FO of the lipid phase of the second ingredient O. The output of the simulation model are the main quality attributes: the average particle size PS and particle size variance PV (compare Fig. 1). These models, which are based on mathematical and physical equations, are fitted, extended, and optimized under consideration of the scarcely available real-plant data and laboratory experimental data. The simulations were only considered at steady state because the reaction time of the mixing chamber was quick regarding the general reaction time of the flows and temperature. It can then be considered as direct multi-input multi-output function of a dynamical model. Since the CFD simulation is much slower than the process' dynamic (e.g., it might take around 10 hours to simulate one physical second of the mixing process), the simulation can't be computed in real time and is executed offline - preferably in advance of the operation of the plant RP or in parallel to the operation of the plant RP. All in all, the offline-simulation model OSM of the dynamical process comprises the mixing process model based on the above-described modelling. However, different simulation or computation techniques might be used for different processes.

Referring to Fig. 2, the obtained offline simulation data SIM-DAT are used for data-based models, so-called artificial intelligences AI, or machine learning models, to generate process models which can be executed in real-time (real time process model RT-PRM). The simulated data can be transferred to the real-time process model RT-PRM via an interface II. The simulated data may be also used to train those models and to adopt them to the respective use-case. As data driven AI models, a linear regression model may be used. For this embodiment a k-nearest neighbor algorithm was advantageous to identify the optimal value combinations (multivariate data vector) in a look-up-table for the state estimations of the process. Other AI models such as deep neural networks, decision trees, reinforcement learning, support vector machines are alternative models might also be used for different use-cases.

The machine learning model ML, which is the core of the real-time process model RT-PRM, represents the real-time process model (here of the mixing process) because it is faster than the process' dynamic (in our scope, hundreds of milliseconds) can calculate the "state" of the production process, based on the measured sensor data (flows and temperatures). The state is typically characterized as product quality or (bio-) chemical attributes which cannot be measured directly by classical sensors. In our case the "state estimations, state parameters" or quality attributes QA are the average particle size PS and particle size variance PV. Thus, a direct correlation is provided between a certain state of the process (here characterized by the quality attributes) and the input parameters of the simulation model OSM (here FA, TA, FO, TO) by the real-time-process model, which allows online operation of the whole process plant.

Additionally, these (bio-)chemical attributes can be estimated with spectrometers and other analytical online devices PAT, which provide estimations only based on statistical correlations (PAT-M) between the PAT device measurement and offline laboratory sample analysis. Therefore, the PAT data can be used to verify and correct the quality estimations of the real-time process model RT-PRM.

However, the plant design with all its automation components still needs to be considered to obtain a complete representation of the production process as digital twin. Therefore, the real-time process model RT-PRM is combined with a simulated plant model SPM. This model simulates standard equipment (e.g., pumps and fluid heater) and correlated standard functions with known techniques such as plant simulation software, virtual controllers so called soft-PLCs, combined with MATLAB Simulink. The latter also allows the design and engineering of control structures which even includes a numeric parameter optimization. The process plant simulation software represents signals, equipment, and behavior of the process plant. The process plant simulation model SPM may be also implemented as real-time simulation model RT-SPM.

The process plant simulation model SPM and the real-time process model RT-PRM (both with a computation time faster than the process' dynamic, here hundreds of milliseconds) form together a virtual plant model VPM. The virtual plant model component VPM can be configured to be run in real-time RT-VPM, if the process plant simulation model is configured as real-time model RT-SPM. The virtual plant model RT-VPM includes all simulation software and models to mimic the real plant in real-time. The virtual plant is able to interact with the real plant. Process variables such as pressure and flow (real-time data RT-D as in Fig. 2) are measured in the real plant and are sent to the virtual plant, which in turn sends back a prediction P of the critical quality attributes to operate the real plant. Together with the ability to predict process quality, based on the offline simulated process data, the virtual plant is a real-time digital twin copy of the real plant. It can work standalone, or together with the real plant as soft sensor.

For the standalone solution no coupling between the real plant RP and the virtual plant VPM exists. All simulations take place offline, that means that, for a relevant predetermined set of input parameters such as process and control parameters and/or measured quality attributes, a prediction P of the quality attribute as an optimal strategy result is stored (file, database). The optimal strategy may be subject to one or more conditions set, e.g. with respect to time or energy. The prediction P is the output of the virtual plant model VPM and can be adjusted and verified by historical data. Additionally new real experiments and production runs (with placebo and real product) can be done to hone the offline process model. For this, PAT sensor data and offline quality analysis data of these runs can be used to fit and verify the offline simulation model.

For the online solution at least one interface I3 between the real plant RP with its automation components, e.g., an automation controller, such as a PLC, and the digital twin of the plant represented by the virtual plant model VPM as simulation component exists and control parameters are derived and exchanged. Once the mixing process is started, the simulation starts in parallel and uses actual control parameters (flow set-points, controlled variables, manipulated variables) to start the optimization calculation. After a reasonable time, the control system of the process automation of the real process plant with all its automation components is receiving new set-points, e.g., in the form of one or more control parameters determined by the virtual plant component RT-VPM, that influence the process, overwriting the current set-points, e.g., in the form of one or more control parameters determined by the RT-VPM component, of the control recipe. The connection with the automation component permits to change set-points in full operation. Ideally, both, the simulation component and the automation component run on the same hardware and software (e.g., Multifunctional Platform S7-1507s PLC, SIMATIC SIMIT, TIA Portal etc. of the company SIEMENS).

Historical data of the process plant and/or historical data of the non-real-time-simulation model and/or historical data of the virtual plant-model and/or historical data from offline experiments can be used to train the machine learning model and/or to improve the virtual plant-model. This illustrates advantageously how the virtual plant model improves continuously due to the increasing amount of generated data. This way a self-adapting system is generated. This embodiment can even be extended in that way that the simulation model of the plant is also continuously updated by operational data from the process plant, what increases the precision of the model and further optimizes the operation of the plant. The digital process twin system for example could comprise of or be connected to a training component, which is connected to a database with historical data of the mentioned models in order to train the machine learning model and in order to improve the performance of process plant and/or of the digital process twin system.

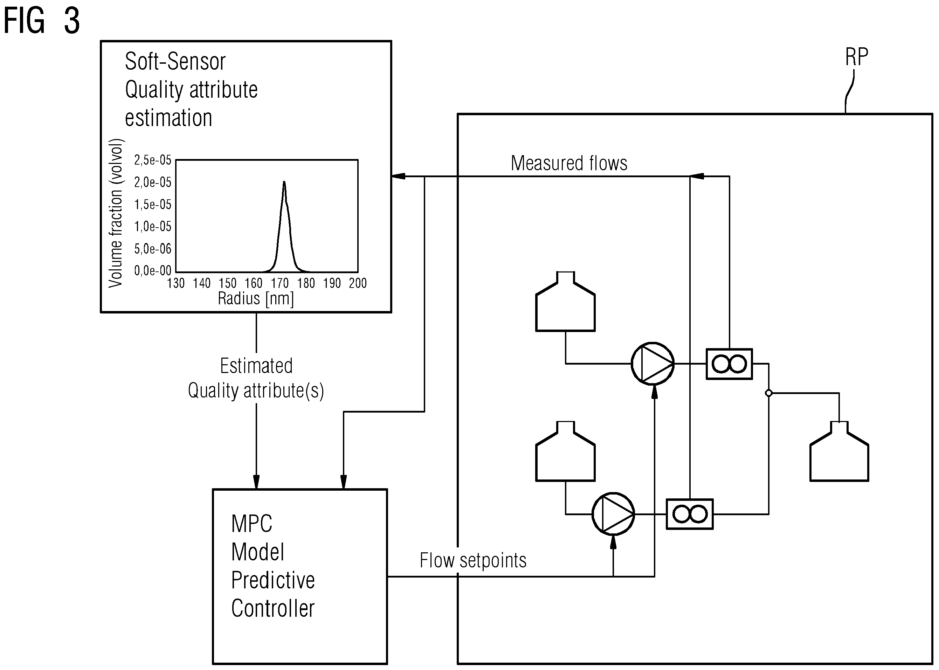

Now turning to Fig. 3, an exemplary embodiment of a control architecture for the disclosed use-case is depicted. In this embodiment the real plant RP is in operation and interacts in real-time with the soft sensor which estimates quality attributes based on its models feeding the estimations to an advanced process control (here MPC) to control the process in the real plant according to previously determined set-points (here flow set-points). Here an online real-time control means a control in accordance with the cycle of the automation system or automation components of the plant in the range of hundreds of milliseconds.

Since the process to be controlled is complex with the request of a minimization of raw material consumption and/or maximization of the yield advanced process controls belong to the preferred solutions for such use-cases. Advanced process controls offer the possibility to exploit and integrate different automation technology domains such as theoretical modeling and simulation. Therefore, in a very advantageous embodiment of this disclosure a model predictive controller MPC is used in combination with the virtual plant model RT-VPM acting as a soft sensor to predict states of the process plant to determine quality attributes of the output product. This way the control architecture as illustrated in Fig. 3 can be seen as advanced closed-loop quality control.

Model predictive control MPC is based on an iterative, finite horizon optimization of a model of the process to be controlled. The prediction horizon of an MPC is repeatedly shifted forward. At each time instance (for example k=1, 2,..., n) MPC uses several components to calculate a series of optimum future control moves. The components used in the calculation include an internal dynamic model of the process, prediction functions to calculate a prediction of future controlled variables without and with control of the process and an optimization cost function over the sliding prediction horizon. Only the first of the series of control moves is applied, after which a new series of future control moves is calculated. The internal dynamic model of the process corresponds to the virtual plant model VPM as depicted in Fig. 2. This model combines a real-time process model as data driven machine learning model and a standard function plant model with Z-transformed Laplace functions for the pumps and the temperature in accordance with MATLAB Simulink. This combined model of soft-Sensor and Z-transformed functions as digital process twin is further used to train and to tune the model predictive controller MPC without having to run costly lab experiment dedicated to control with steps, micro steps or sinusoidal action on the flows. This means that the dynamical model inside the MPC can be trained on the simulated data as generated by the digital process twin only. Real process variables can be used additionally but are not necessary as for common MPCs. By optimization the cost function of the MPC over the sliding prediction horizon based on the virtual plant model VPM the MPC can be tuned. This way the MPC can improved continuously over time. It should be noted that the optimization of the MPC, just as the optimization of the virtual plant model VPM can be performed offline without coupling to the real plant. This is possible due to the fact that only simulated data are used to train the models and to update them.

During operation of the real plant RP, PAT information and model-based state estimators are available to assess the actual product quality. Different estimations of the same attribute can be combined using techniques such as a Kalman filter. The probability of the predicted quality parameters (as achieved by the real-time state estimator) and the probability of the measured quality parameters (as achieved by the PAT measurements) represent not only probability distributions of possible errors around each estimate, but also correlations between estimation errors of different variables. Based on probabilities of previous and current estimates and the probabilities of the measured values of the quality attributes, at each cycle the previous estimates are combined with the new measurements in an optimal way, so that remaining errors of the filter state are minimized as fast as possible. After each new measurement, the Kalman filter improves the previous estimates and updates the associated error estimates and correlations. Due to the robustness of this estimator, the MPC trained in the virtual plant can be used in the real plant. It will steer the pumps towards higher and lower speeds based on the measured deviation to the required quality specifications.

## Claims

1. A method of operation of a process plant with at least one automation component (PA) to control an industrial process (MP) within the process plant with at least one input ingredient and at least one output product, the method comprising the steps of:
- generating quality attributes of the industrial process as a function of process variables and process parameters using a non-real-time simulation model (OSM) of the industrial process,
- using the generated quality attributes and related process variables as input for a machine learning model (ML) which is used as real-time process model (RT-PRM),
- using the real-time process model (RT-PRM) as a soft sensor to estimate quality attributes (QA) of the output product as a function of measured or simulated process variables of the industrial process, and
- optimizing the performance of the process plant based on the estimated quality attributes (QA) of the output product.

2. The method according to claim 1,
wherein a process plant simulation model (SPM) is used to generate the simulated process variables (SD) of the industrial process.

3. The method according to claim 1 or 2,
wherein the process plant simulation model (SPM) is a real-time model and whereby the real-time process plant simulation model (RT-SPM) and the real-time process model (RT-PRM) are combined to a real-time virtual plant model (RT-VPM) to estimate or predict states of the process plant to optimize the performance of the process plant.

4. The method according to claim 1, 2 or 3,
wherein the real-time process model (RT-PRM) or the real-time virtual plant model (RT-VPM) is used for an online control of the process plant, which is preferably an advanced, adaptive process control, like a model predictive control (MPC).

5. The method according to any of the preceding claims, wherein the industrial process is a pharmaceutical production process, especially a mixture process of two liquids.

6. A Soft Sensor for a process plant with at least one automation component (PA) to control an industrial process (MP) within the process plant (RP) with at least one input ingredient and at least one output product, comprising:
- an interface (II) to receive quality attributes and related process variables of the industrial process from a non-real-time simulation model component (OSM) to simulate the behavior of the industrial process, and
- a real-time process model (RT-PRM) component,
comprising a machine learning model (ML),
wherein the machine learning model (ML) is based on the received quality attributes and related process variables of the simulation model component (OSM), and
wherein the machine learning model (ML) is configured to estimate quality attributes (QA) of the output product as a function of measured or simulated process variables of the industrial process.

7. The Soft Sensor of claim 6,
further comprising the non-real-time simulation model component (OSM), being connected to the interface (II).

8. The Soft Sensor of claim 6 or 7,
further comprising a Kalman filter which is configured to receive the estimated and measured quality attributes of the output product and to calculate improved estimates based on probabilities of previous and current estimates and measured values of the quality attributes.

9. Use of the soft sensor according to claim 6 to 8 as process model for a model predictive controller (MPC).

10. A digital process twin system for operation of a process plant with at least one automation component (PA) to control an industrial process (MP) within the process plant with at least one input ingredient and at least one output product, comprising
a virtual plant model component (VPM) with
- an interface (12) to receive quality attributes and related process variables of the industrial process from a non-real-time simulation model component (OSM) to simulate the behavior of the industrial process,
- a real-time process model (RT-PRM) component,
comprising a machine learning model (ML),
wherein the machine learning model (ML) is based on the received quality attributes and related process variables of the non-real-time simulation model component (OSM), and
- a process plant simulation model component (SPM),
which is configured to simulate automation functions and operation of the process plant to generate simulated process variables (SD),
wherein the machine learning model is configured to estimate quality attributes (QA) of the output product as a function of measured or the simulated process variables of the industrial process.

11. The digital process twin system of claim 10, wherein the measured process variables are real-time data (RT-D) of the process plant (RP).

12. The digital process twin system of claim 10 or 11, wherein the process plant simulation model component (SPM) is a real-time model (RT-SPM).

13. The digital process twin system of claim 10 to 12, wherein the virtual plant model component (VPM) is configured to be run in real-time (RT-VPM) in parallel to the process plant (RP) to estimate or predict states of the process plant in real-time based on the estimated quality attributes (QA) of the output product.

14. The digital process twin system of claim 13, wherein the real-time virtual plant model component (RT-VPM) is configured to be run in connection with a control component, preferably a model predictive controller (MPC), to control the real plant (RP) based on the estimated or predicted states generated by the real-time virtual plant model (RT-VPM) thus providing a closed-loop control of quality of the output product.

15. The digital process twin system of claim 12, wherein the virtual plant model component (VPM) comprises an interface (13) to provide the simulated process variables and/or the estimated quality attributes to a model predictive controller (MPC) for tuning the model predictive controller (MPC) for operation in the real plant.

16. Use of the digital process twin system according to claim 10 to 15 to optimize the operation of a plant for a pharmaceutical production process, especially a mixture process of two liquids.

17. A Computer program product comprising program code that when executed, causes at least one processor to carry out any one of the method steps of claims 1 to 5.
